# DEMANDE DE BREVET EUROPEEN

(11) **EP 4 593 285 A1**
(43) Date de publication de la demande: **30.07.2025**
(21) Numéro de dépôt: 25153365.9
(22) Date de dépôt: 22.01.2025
(51) Int. Cl.: H02S 20/00, H02S 20/10, H02S 30/20

(54) **GÉNÉRATEUR ÉLECTRIQUE, PROCÉDÉ DE CONVERSION ET PROCÉDÉ D'UTILISATION D'UN TEL GÉNÉRATEUR**

(30) Priorité: 25.01.2024 FR 2400753
(71) Demandeur: POMA, 38340 Voreppe (FR)
(72) Inventeur: BABAZ, Mathieu, 38340 Voreppe (FR)
(74) Mandataire: Talbot, Alexandre

(57) **Abrégé**

Un générateur électrique comporte des modules photovoltaïques (1), une station (6) et une station additionnelle (10) reliées par un câble porteur (4a) supportant les modules photovoltaïques (1) et un câble tracteur (4b) déplaçant les modules photovoltaïques (1). Chaque module photovoltaïque (1) est fixé au câble tracteur (4b) par un connecteur (5) débrayable. Une station (6) est munie de moyens de déplacement du câble tracteur (4b) pour déplacer les modules photovoltaïques (1) le long de la boucle par rapport à la station (6). Un circuit de commande (9) est configuré pour déplacer les modules photovoltaïques (1) d'une position de production à une position de repos en déplaçant le câble tracteur (4b).

## Description

### Domaine technique

L'invention est relative à un générateur électrique, à un procédé de conversion et à un procédé d'utilisation d'un tel générateur électrique.

### Technique antérieure

Afin de limiter la consommation des énergies fossiles, il existe une volonté d'utiliser plus intensément les panneaux photovoltaïques. Cependant, il n'est pas toujours aisé de trouver des surfaces aptes à recevoir des panneaux photovoltaïques. Le document US4,154,221 propose de poser le panneau photovoltaïque sur un cadre qui autorise l'ajustement de l'inclinaison du panneau photovoltaïque pour s'adapter à la latitude de l'exploitation et qui autorise le pivotement du panneau photovoltaïque pour suivre la course du soleil. Cette configuration est peu pratique car elle entraine une occupation importante du sol.

Il est connu d'utiliser des ombrières formées par des panneaux photovoltaïques montés fixement sur une structure rigide, par exemple une zone de stationnement comme cela est illustrée dans le document JP2014-122493. Il est également connu des documents EP2669594 ou WO2017/093540 de former une ombrière mobile. La structure de l'ombrière possède des câbles ou des rails qui s'étendent le long de la zone de stationnement. En tirant sur un câble tracteur, on déplie ou on replie un ensemble de panneaux photovoltaïques qui sont associés les uns aux autres par des charnières. Dans la position repliée, les multiples panneaux photovoltaïques sont disposés les uns contre les autres à l'intérieur d'un containeur.

Il est également connu du document FR3099861 de former une ombrière au-dessus de zones agricoles ou d'une exploitation animale. Selon les configurations, les panneaux photovoltaïques sont fixés à des mats ou ils sont installés fixement à des câbles qui sont tirés le long de la parcelle agricole. Les panneaux photovoltaïques sont montés mobiles à pivotement par rapport aux câbles afin d'ajuster la quantité de rayonnement que doivent recevoir les arbres et les cultures.

Il est encore connu d'installer des panneaux photovoltaïques au-dessus de plans d'eau, par exemple des lacs ou des rivières. Là encore, il est possible de tirer des câbles d'une berge à l'autre et d'installer les panneaux photovoltaïques sur des flotteurs. Un tel enseignement est présenté dans les documents FR3016686 ou JP2004-235188.

Ces trois derniers exemples de réalisation permettent d'utiliser des surfaces plus ou moins importantes. Cependant, ces trois exemples se caractérisent également par une difficulté de mise en oeuvre des interventions de maintenance, par exemple après un épisode climatique intense, notamment après un épisode de grêle, pour réparer un panneau photovoltaïque endommagé. En effet, la zone située sous les panneaux photovoltaïques est utilisée ou elle est peu pratique ce qui complique la mise en place d'une intervention rapide et à grande échelle. Il en est de même lorsque les panneaux photovoltaïques sont installés au-dessus d'un précipice ce qui nécessite des moyens d'intervention importants.

Dans des installations où les panneaux photovoltaïques sont disposés de manière quasiment fixe sur un support formé par des câbles, il est connu de plier les panneaux photovoltaïques afin de modifier l'inclinaison de la surface de collecte pour faciliter l'évacuation de l'eau de pluie ou de la neige. Un tel exemple de réalisation est illustré dans le document WO2013/044404. Une partie des panneaux est montée fixement alors que l'autre partie est déplacée au moyen d'un câble mobile ce qui permet de définir l'angle de la surface de collecte par rapport à une direction de référence.

Selon un autre mode d'exploitation, les panneaux photovoltaïques sont installés sur un filet qui s'étend principalement selon la direction verticale. Les panneaux photovoltaïques sont arrangés en rangées et en colonnes à la surface du filet. Les panneaux photovoltaïques sont montés pivotants afin de suivre la course du soleil au sein d'une même colonne. La surface utilisée au sol est importante et les panneaux photovoltaïques les plus hauts sont difficilement accessibles.

Il existe également une structure support formée par des pylônes reliés par deux câbles disposés parallèlement. Les panneaux photovoltaïques sont fixés au câble à chacune de leurs extrémités. Les interventions de maintenance sont compliquées à mettre en oeuvre.

Il est encore connu de fixer des panneaux photovoltaïques à un ou plusieurs câbles qui forment la partie de support. Le support peut comporter deux câbles qui sont décalés l'un de l'autre de manière à définir l'inclinaison par rapport à un plan horizontal. Les câbles sont fixés sur des pylônes de remontées mécaniques au-dessus du câble tractant les véhicules. Un tel exemple de réalisation est présenté dans les documents US 2011 /0155218 et WO 2015/169396.

Il est connu du document ES 1295389 un mode de réalisation où deux câbles porteurs s'étendent continûment et de manière rectiligne d'un premier ancrage à un deuxième ancrage. Des cadres sont installés mobiles le long des deux câbles porteurs au moyen de roues disposées aux quatre coins du cadre et qui roulent sur les câbles porteurs. Les cadres sont accrochés à deux câbles tracteurs qui s'étendent d'un ancrage à l'autre. De multiples panneaux photovoltaïques sont disposés sur les cadres pour capter du rayonnement solaire. Les cadres sont installés sur les câbles porteurs puis ils sont accrochés manuellement les uns aux autres. Cette solution technique apparait compliquée à gérer car tous les cadres doivent être installés et retirés manuellement depuis un ancrage. En cas de défaillance d'un panneau photovoltaïque, il est nécessaire de retirer ou de démonter tous cadres situés entre le panneau photovoltaïque défaillant et l'ancrage. Lorsque les conditions météorologiques se dégradent, il convient également d'intervenir sur les cadres pour éviter de trop solliciter les câbles.

### Objet de l'invention

Un objet de l'invention consiste à prévoir un générateur électrique dont l'emprise au sol est réduite tout en autorisant une gestion facile des multiples modules photovoltaïques utilisés notamment lors d'opérations de maintenance et/ou de rem placement.

On tend à résoudre ce problème au moyen d'un générateur électrique comportant :
- des modules photovoltaïques définissant chacun une surface de collecte destinée à collecter du rayonnement solaire ;
- une station munie d'une poulie ;
- une poulie de renvoie ;
- au moins un câble aérien reliant la poulie et la poulie de renvoie pour définir une boucle, le au moins un câble aérien comportant au moins un câble porteur destiné à supporter les modules photovoltaïques et au moins un câble tracteur destiné à déplacer les modules photovoltaïques ;
- un dispositif de déplacement configuré pour déplacer le au moins un câble tracteur et déplacer les modules photovoltaïques le long de la boucle par rapport à la au moins une station ;
- un circuit de commande configuré pour déplacer le au moins un câble tracteur et déplacer au moins des modules photovoltaïques d'une position de production à une position de repos située dans la station.

Le générateur électrique est remarquable en ce que le générateur électrique comporte en outre une pluralité de connecteurs, chaque module photovoltaïque étant fixé audit au moins un câble tracteur au moyen d'au moins un connecteur et en ce que les connecteurs sont des connecteurs débrayables pour désolidariser le au moins un câble tracteur et les modules photovoltaïques en station.

De manière avantageuse, le au moins un câble porteur est également le au moins un câble tracteur.

Dans une configuration particulière, chaque module photovoltaïque est fixé au câble tracteur indépendamment des autres modules photovoltaïques par au moins un connecteur.

Préférentiellement, les modules photovoltaïques sont montés mobiles les uns par rapport aux autres selon au moins une direction perpendiculaire à un axe longitudinal du au moins un câble aérien par déformation du au moins un câble aérien.

Selon un mode de réalisation, chaque module photovoltaïque est connecté au connecteur par un bras, le bras étant librement pivotant par rapport au connecteur pour suivre le vecteur gravité indépendamment de l'inclinaison du au moins un câble porteur et figer l'inclinaison de la surface de collecte par rapport à la direction verticale.

De manière préférentielle, chaque module photovoltaïque comporte un dispositif de pivotement configuré pour faire pivoter la surface de collecte par rapport au bras et au connecteur et pour ajuster une inclinaison de la surface de collecte du module photovoltaïque par rapport à une direction verticale dans la position de production, l'ajustement étant réalisé selon au moins une direction.

Avantageusement, l'ajustement est réalisé selon deux directions orthogonales.

Dans un mode de réalisation particulier, le circuit de commande est muni ou relié à un module météorologique et configuré pour modifier l'inclinaison de la surface de collecte à réception d'un signal représentatif de conditions météorologiques prédéterminées constituées par des vitesses de vents supérieures à une vitesse seuil, un épisode de grêle, une chute de neige, un épisode pluvieux.

Dans un développement préférentiel, au moins l'un des modules photovoltaïques est fixé au câble aérien par deux connecteurs débrayables. Au moins un des modules photovoltaïques est pliable au moyen d'au moins une liaison pivot disposée entre deux panneaux photovoltaïques connectés chacun audit au moins un câble tracteur par un connecteur débrayable pour augmenter ou réduire une longueur du au moins un des modules photovoltaïques par pliage entre les deux connecteurs débrayables entre la position de repos et la position de production, la longueur du module photovoltaïque étant mesurée selon la direction longitudinale du au moins un câble aérien ou une direction de déplacement du module photovoltaïque.

Dans une configuration avantageuse, la station définit au moins un local de stockage apte à stocker au moins une partie des modules photovoltaïques déconnectés du au moins un câble aérien dans la position de repos.

Dans un mode de réalisation particulier, le générateur électrique comporte une station additionnelle munie de la poulie de renvoie et disposée à une altitude différente de la station. La station additionnelle définit au moins un local de stockage apte à stocker une partie des modules photovoltaïques. Dans un état de repos, une première partie des modules photovoltaïques est stockée dans la station et une deuxième partie des modules photovoltaïques est stockée dans la station additionnelle, les modules photovoltaïques étant répartis sur les deux brins du au moins un câble aérien, les modules photovoltaïques en position de production étant disposés sur deux brins de la boucle reliant la station et la station additionnelle.

Dans un développement préférentiel, le circuit de commande est muni ou relié à un module météorologique et configuré pour déplacer les modules photovoltaïques de la position de production à la position de repos à réception d'un signal représentatif de conditions météorologiques néfastes constitué par des vitesses de vents supérieures à une vitesse seuil, un épisode de grêle, une chute de neige.

De manière avantageuse, au moins un brin du câble tracteur forme un virage à gauche et/ou un virage à droite dans une observation verticale.

Préférentiellement, le au moins un câble porteur définit deux brins qui s'étendent de manière rectiligne entre la station et la station additionnelle. Les modules photovoltaïques sont disposés sous le au moins un câble porteur. Les modules photovoltaïques sont répartis sur les deux brins du au moins un câble aérien.

Dans un mode de réalisation avantageux, plusieurs des modules photovoltaïques sont connectés à chacune de leurs extrémités selon la direction longitudinal du au moins un câble aérien à deux modules photovoltaïques adjacents. Le module photovoltaïque est connecté audit module photovoltaïque adjacent par une liaison pivot.

Préférentiellement, les modules photovoltaïques sont accrochés audit au moins un câble aérien par deux connecteurs disposés aux extrémités opposées du module photovoltaïque selon la direction longitudinale pour former deux connecteurs d'extrémité. Les connecteurs d'extrémité accrochent deux modules photovoltaïques adjacents. Les deux modules photovoltaïques adjacents sont reliés par une liaison pivot.

Avantageusement, les modules photovoltaïques adjacents s'étendent continûment de la station à la station additionnelle.

L'invention a également pour objet un procédé de conversion d'une installation de transport par câble en un générateur d'énergie.

On tend à atteindre ce résultat au moyen d'un procédé de conversion d'une installation de transport par câble en générateur d'énergie selon l'une quelconque des configurations précédentes :
- fournir une installation de transport par câble comportant des véhicules, une station et une station additionnelle reliée par au moins un câble porteur destiné à supporter les véhicules et au moins un câble tracteur destiné à déplacer les véhicules, le câble tracteur formant une boucle, le câble porteur et le câble tracteur étant des câbles aériens, chaque véhicule étant fixé au câble tracteur, l'installation comportant également un dispositif de déplacement du au moins un câble tracteur pour déplacer les véhicules le long de la boucle par rapport à la au moins une station ;
- remplacer les véhicules par des modules photovoltaïques, les modules photovoltaïques ;
et dans lequel un circuit de commande est configuré pour déplacer les modules photovoltaïques d'une position de production à une position de repos en déplaçant le au moins un câble tracteur.

L'invention a également pour objet un procédé d'utilisation d'un générateur d'énergie qui est plus facilement exploitable que les configurations de l'art antérieur.

On tend à atteindre ce résultat au moyen d'un procédé d'utilisation d'un générateur d'énergie selon l'une quelconque des configurations précédentes comportant les étapes suivantes :
- déplacer le câble tracteur pour déplacer au moins un des modules photovoltaïques depuis une position de production jusqu'à une position de repos.

### Description sommaire des dessins

D'autres avantages et caractéristiques ressortiront plus clairement de la description qui va suivre de modes particuliers de réalisation et de mise en oeuvre de l'invention donnés à titre d'exemples non limitatifs et représentés aux dessins annexés, dans lesquels :
- la figure 1 illustre schématiquement une vue d'un générateur électrique ;
- la figure 2 illustre schématiquement une vue d'un premier mode de réalisation d'un module photovoltaïque avec une pince attachée à un câble porteur-tracteur ;
- la figure 3 illustre schématiquement une vue d'un deuxième mode de réalisation d'un module photovoltaïque avec deux pinces débrayables attachées à un câble porteur-tracteur ;
- la figure 4 illustre schématiquement une vue d'un troisième mode de réalisation d'un module photovoltaïque avec deux pinces attachées à un câble tracteur et des galets roulants sur un câble porteur ;
- la figure 5 illustre schématiquement une vue d'un quatrième mode de réalisation d'un module photovoltaïque avec deux pinces attachées à un câble tracteur et des galets roulants sur deux câbles porteurs ;
- la figure 6 illustre schématiquement une vue d'un cinquième mode de réalisation d'un ensemble de plusieurs modules photovoltaïques qui sont montés pliables les uns par rapport aux autres, l'extrémité droite de l'ensemble étant connectée au câble tracteur par un connecteur débrayable et l'extrémité gauche étant connectée à un support.

### Description des modes de réalisation

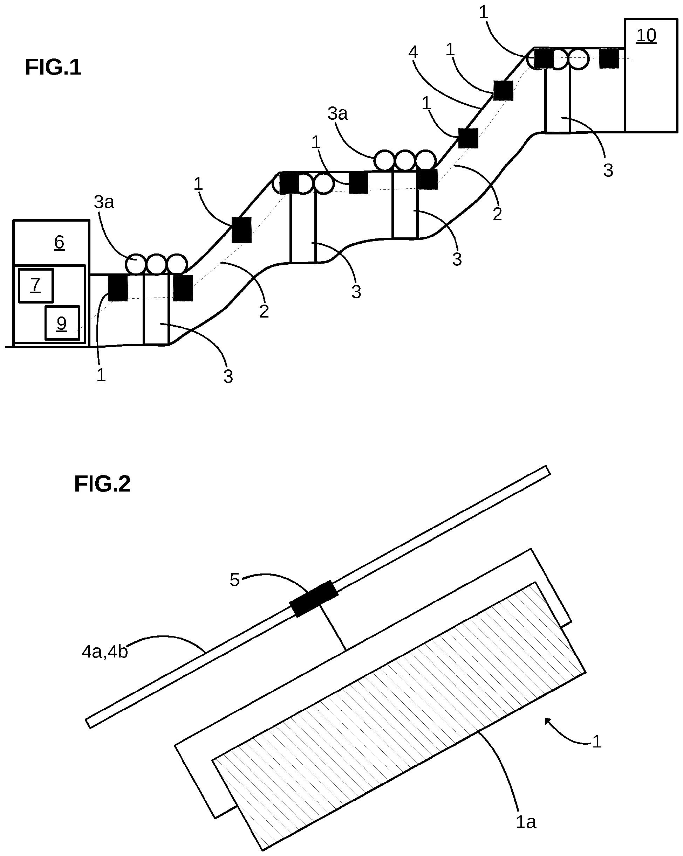

La figure 1 illustre un exemple de réalisation d'un générateur électrique qui est un générateur électrique photovoltaïque. Le générateur électrique comporte une pluralité de modules photovoltaïques 1. Chaque module photovoltaïque 1 possède un ou plusieurs panneaux photovoltaïques 1a qui possèdent une surface de collecte du rayonnement solaire. Le rayonnement solaire reçu par chaque panneau photovoltaïque 1 est transformé en un courant électrique. Le ou les panneaux photovoltaïques 1a définissent une surface de collecte du rayonnement solaire avec un plan de captation du rayonnement qui peut être le plan défini par la surface supérieure du panneau photovoltaïque 1a.

Préférentiellement, le courant électrique produit par chaque module photovoltaïque 1 est acheminé à une borne de sortie électrique par au moins une liaison électrique 2. En alternative ou en complément, chaque module photovoltaïque 1 est connecté à une batterie.

Le au moins un câble aérien 4 est disposé en hauteur au-dessus du sol afin de ne pas empêcher l'exploitation du sol situé sous les modules photovoltaïques 1. Le au moins un câble aérien 4 possède un câble porteur 4a et un câble tracteur 4b. Par un câble porteur 4a, on entend au moins un câble porteur 4a, par exemple deux câbles porteurs 4a. Par un câble tracteur 4b, on entend au moins un câble tracteur 4b, par exemple deux câbles tracteurs 4b.

Le générateur électrique possède une station 6 et une station additionnelle 10 qui sont chacune munies d'une poulie. Les poulies coopèrent avec le câble tracteur 4b pour former une boucle. Le câble tracteur 4b peut être divisé en deux brins distincts qui sont délimités par la station 6 et la station additionnelle 10. La boucle définit le chemin de circulation des modules photovoltaïques 1 entre la station 6 et la station additionnelle 10. Le générateur électrique peut comporter plus de stations et la forme de la boucle peut être quelconque.

Le générateur électrique est muni d'un dispositif d'entrainement 7 qui est configuré pour déplacer le câble tracteur 4b. Le câble tracteur 4b se déplace par rapport aux stations ce qui permet de déplacer les modules photovoltaïques 1 le long de la boucle pour se rapprocher ou s'éloigner de la station 6 ou de la station additionnelle 10. Par exemple, le dispositif d'entrainement 7 coopère avec une des poulies qui forme une roue d'entrainement qui est animée en rotation. Le dispositif d'entrainement 7 comporte préférentiellement un moteur.

Le au moins un câble porteur 4a est destiné à porter ou supporter les multiples modules photovoltaïques 1. Le au moins un câble tracteur 4b est destiné à déplacer les multiples modules photovoltaïques 1. Le au moins un câble tracteur 4b définit la boucle de câble. Les modules photovoltaïques 1 sont accrochés au câble tracteur 4b les uns derrière les autres sur au moins une partie de la boucle et de préférence sur toute la longueur de la boucle. Les connecteurs 5 peuvent réaliser un tour complet de la boucle de la station 6 jusqu'à la station 6 en traversant la station additionnelle 10 ou de la station additionnelle 10 à la station additionnelle 10 en traversant la station 6. Le connecteur 5 passe successivement du premier brin au deuxième brin ou du deuxième brin au premier brin. Le déplacement d'un connecteur accroché au premier bin correspond au déplacement équivalent d'un connecteur accroché au deuxième brin. Lors de la traversée de la station 6 ou de la station additionnelle 10, les connecteurs 5 se déplacent en étant tractées par le câble tracteur 4b ou un support 6a selon la portion de la station 6 ou de la station additionnelle 10 qui est empruntée.

De manière préférentielle, le générateur électrique possède un ou plusieurs pylônes 3 qui sont destiné à supporter le câble tracteur 4b et/ou le câble porteur 4a. La boucle peut définir une ligne droite entre la station 6 et la station additionnelle 10. Il est également possible que le câble aérien 4 qui relie la station 6 à la station additionnelle 10 définisse un changement de direction, par exemple un virage à droite ou à gauche selon une observation verticale.

Préférentiellement, le au moins un câble aérien 4 est disposé à une hauteur telle que la distance entre le sol et le module photovoltaïque 1 le plus proche autorise le passage d'un véhicule ou d'une personne. Par exemple, la distance est supérieure à 3 mètres. L'accrochage des modules photovoltaïques 1 sur le câble aérien 4 permet d'installer les modules photovoltaïques 1 en hauteur ce qui permet de ne pas occuper la surface du sol entre les stations et éventuellement entre les pylônes 3. Ce montage autorise la circulation de personnes, d'animaux ou de véhicules entre deux pylônes 3 y compris lorsque les modules photovoltaïques 1 produisent de l'électricité. Sous le câble aérien 4 et les modules photovoltaïque 1, il est possible d'y avoir un plan d'eau, une rivière, un précipice, un axe de circulation, par exemple une route pour automobiles ou une voie ferrée. Il est également possible d'y avoir une construction, par exemple, une maison, un immeuble ou un bâtiment industriel.

Le générateur électrique est muni d'une pluralité de connecteurs 5 qui réalisent la connexion entre le au moins un câble aérien 4 et les modules photovoltaïques 1. Le connecteur 5 est muni d'un premier module de connexion qui réalise la liaison entre le module photovoltaïque 1 et le câble porteur 4a. Le premier module de connexion peut être quelconque, par exemple un galet 8, un crochet, une glissière ou tout autre élément apte à glisser ou rouler le long du câble porteur 4a.

Le connecteur 5 est muni d'un deuxième module de connexion qui réalise la liaison entre le module photovoltaïque 1 et le câble tracteur 4b. Le deuxième module de connexion peut être quelconque, par exemple une pince ou tout autre moyen capable de s'accrocher au câble tracteur 4b pour entrainer le module photovoltaïque 1 en déplacement pour se rapprocher ou s'éloigner de la station 6. Un rapprochement de la station 6 correspond à un éloignement de la station additionnelle 10 et inversement selon la direction longitudinale du câble tracteur 4b.

Selon les modes de réalisation, le générateur électrique peut comporter un ou plusieurs câbles porteurs 4a et un ou plusieurs câbles tracteurs 4b. Chaque module photovoltaïque 1 est accroché à un ou plusieurs câbles tracteur 4b au moyen d'au moins un connecteur 5 de la pluralité de connecteurs 5.

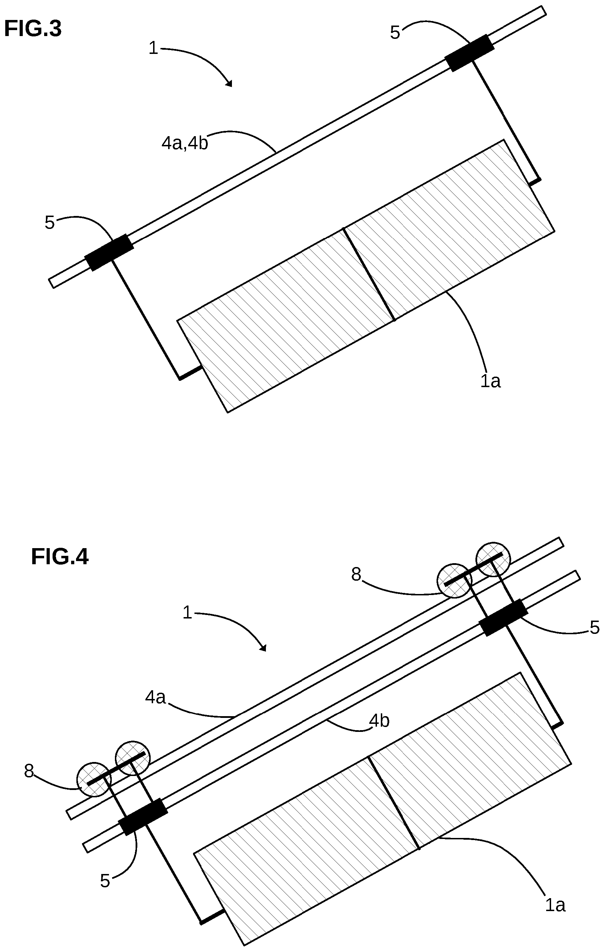

Dans un mode de réalisation, le câble tracteur 4b est également un câble porteur 4a, le ou les connecteurs 5 sont préférentiellement formés par des pinces qui peuvent être la seule connexion mécanique entre le module photovoltaïque 1 et le câble aérien 4. Avantageusement, dans ce cas de figure, le câble aérien 4 est unique. Les figures 2 et 3 illustrent un mode de réalisation dans lequel le module photovoltaïque 1 est accroché à un unique câble aérien 4 qui est un câble porteur-tracteur. La figure 2 illustre une fixation au moyen d'une seule pince. La figure 3 illustre une fixation au moyen de deux pinces.

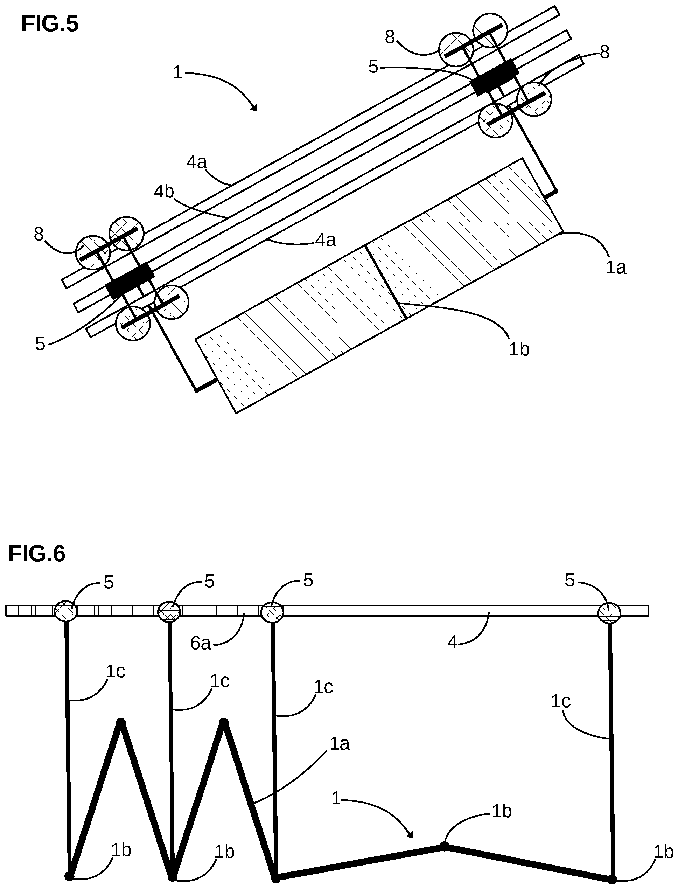

Il est également possible de prévoir que le au moins un câble aérien 4 possède plusieurs câbles porteurs-tracteurs, par exemple deux câbles porteurs-tracteurs. Il est encore possible de prévoir que les câbles aériens 4 possèdent un ou plusieurs câbles porteurs 4a qui sont distincts du ou des câbles tracteurs 4b. Les figures 4 et 5 illustrent des fixations avec un câble tracteur 4b et un ou plusieurs câbles porteurs 4a.

Le déplacement du au moins un câble tracteur 4b déplace les modules photovoltaïques 1 par rapport à la station 6 le long de la boucle et par rapport aux pylônes 3 selon la direction longitudinale du câble aérien 4. Le dispositif d'entrainement 7 permet de rapprocher les modules photovoltaïques 1 de la station 6 ou de les éloigner de la station 6.

Le déplacement du au moins un câble tracteur 4b déplace les modules photovoltaïques 1 entre une position de production et une position de repos. Dans la position de production, le module photovoltaïque 1 est disposé à distance de la station 6 dans une zone où il est apte à recevoir du rayonnement lumineux et donc générer du courant électrique. Dans la position de production, le module photovoltaïque 1 est à l'arrêt, c'est-à-dire que le câble tracteur 4a ne se déplace pas entrainé par le dispositif d'entrainement 7.

Dans la position de repos, le module photovoltaïque 1 est plus facilement accessible que dans la position de production, par exemple le module photovoltaïque 1 est disposé à moins de 1,5m du sol pour faciliter les interventions sans échelle, échafaudage ou équipement de travail en hauteur. Préférentiellement, la position de repos est une position où le module photovoltaïque est dans la station 6.

Le module photovoltaïque 1 est disposé dans une zone de stockage, par exemple un local de stockage destiné à le protéger des conditions météorologiques, ou dans une zone de maintenance, par exemple un local de stockage dans lequel une intervention sur le module photovoltaïque 1 est plus facile que dans la position de production. De préférence, la zone de stockage réduit ou bloque la captation de rayonnement lumineux naturel.

De manière préférentielle, la zone de stockage est une zone de la station 6. Il en est avantageusement de même pour la zone de maintenance.

Les modules photovoltaïques 1 sont montés mobiles de manière à pouvoir se déplacer entre la position de production et la position de repos.

Comme indiqué plus haut, dans la position de production, les modules photovoltaïques 1 sont installés en hauteur ce qui rend les interventions de maintenance compliquées voire impossibles. Il apparait compliqué de réaliser une opération de maintenance sur des panneaux disposés au-dessus d'un précipice, d'un cours d'eau ou d'une voie de circulation. En outre, une intervention en hauteur nécessite la mise en place de dispositifs de sécurité visant à protéger le personnel qui intervient ainsi que d'éventuelles personnes qui pourraient se déplacer sous ou à proximité du module photovoltaïque 1 sujet de l'intervention.

Enfin, la maintenance nécessitant la mise en place d'un protocole d'intervention complexe, elle ne peut être réalisée rapidement, par exemple suite à la détection d'une défaillance sur un des modules photovoltaïques. Il est donc particulièrement avantageux de pouvoir déplacer chaque module photovoltaïque 1 jusqu'à une zone d'intervention qui est préférentiellement la station 6 ou la station additionnelle 10. L'intervention, dans la zone de repos permet de rapprocher le module photovoltaïque 1 du sol et éventuellement de le protéger des conditions météorologiques extérieures.

Le générateur électrique peut posséder des pylônes 3, un ou plusieurs câbles aériens 4 et un dispositif d'entrainement 7 configuré pour entrainer le ou les câbles aériens 4 qui peuvent être identiques à ceux utilisés dans les installations de transport par câble, par exemple ceux utilisés en montagne et/ou dans le transport urbain. Les pylônes 3 sont préférentiellement munis de galets 3a qui supportent ou compriment le au moins un câble aérien 4. Ces technologies sont bien maitrisées ce qui facilite la réalisation d'une installation économique et fiable.

Dans la position de production, les modules photovoltaïques 1 ne sont pas destinés à se déplacer ce qui limite la consommation électrique et rend l'installation énergétiquement intéressante. Dans leurs positions de production, les modules photovoltaïques 1 sont tous fixés au câble tracteur 4b et ils sont espacés d'une distance fixe qui peut être différente entre chaque groupe de deux modules photovoltaïques 1 consécutifs. Dans la position de production, les connecteurs 5 sont accrochés fixement au câble tracteur 4b.

Dans un mode de réalisation particulier, les modules photovoltaïques 1 sont dissociés mécaniquement les uns des autres. En d'autres termes, les modules photovoltaïques 1 sont disposés à distances les uns des autres et ils sont uniquement reliés par le câble porteur 4a et le câble tracteur 4b. Le câble porteur 4a et le câble tracteur 4b forment une liaison souple qui autorise un déplacement d'un module photovoltaïque 1 par rapport aux autres modules photovoltaïques 1 selon au moins une direction perpendiculaire à la direction longitudinale du câble porteur 4a et de préférence qui autorise déplacement d'un module photovoltaïque 1 par rapport aux autres modules photovoltaïques 1 selon plusieurs directions perpendiculaires à la direction longitudinale du câble porteur 4a.

Lorsque les modules photovoltaïques 1 sont balayés par le vent, le câble porteur 4a et le câble tracteur 4b peuvent se déformer afin d'absorber les efforts induits. Cette construction permet de limiter les efforts sur les modules photovoltaïques 1 qui réalisent la prise au vent ce qui permet de faciliter la production d'électricité y compris lorsque le vent présente une vitesse importante cela réduit l'occurrence des conditions nécessitant le déplacement des modules photovoltaïques 1 de la position de production à la position de repos. De manière préférentielle, les modules photovoltaïques sont connectés de proche en proche aux modules photovoltaïques 1 immédiatement adjacents par une connexion électrique qui est également une liaison souple.

Cette configuration est plus avantageuse que celle divulguée dans les documents US2011/0253193, US2016/0173025, WO2017/093540 et, EP2669594 où chaque module photovoltaïque est connecté à ses deux modules voisins par une charnière ce qui implique la transmission des efforts entre les modules. Lorsque les modules photovoltaïques sont soumis au vent, ce dernier applique des efforts différents tant dans leurs intensités que dans leurs directions selon les panneaux photovoltaïques. Les charnières et les modules photovoltaïques sont soumis à des contraintes importantes afin de conserver la cohésion mécanique de l'ensemble. Cela se traduit également par l'application d'efforts importants sur la structure support. Lorsque le vent souffle fortement, il est nécessaire de replier les modules photovoltaïques.

Au contraire, l'utilisation d'une liaison souple entre les modules photovoltaïques 1 permet de réduire les efforts appliqués dans les modules photovoltaïques 1 ainsi que sur l'ensemble de la structure porteuse. Il est alors possible d'utiliser la position de production pour des vitesses du vent qui sont plus importantes que dans les configurations de l'art antérieur sans augmenter les contraintes mécaniques sur les pylônes 3 et sur les stations 6 et 10.

La liaison électrique 2 est préférentiellement une liaison flexible, de préférence plus flexible que le câble porteur 4a, de préférence plus flexible que le câble porteur 4a et le câble tracteur 4b.

Les modules photovoltaïque 1 étant indépendants les uns des autres et connectés par une liaison électrique 2, en cas de défaillance d'un module photovoltaïque 1 ou de sa liaison électrique 2, il est possible de déplacer le module photovoltaïque 1 défaillant jusqu'à la position de repos pour réaliser la réparation nécessaire.

Dans un mode de réalisation particulier, le module photovoltaïque est remplacé par un autre module photovoltaïque lors d'une intervention en station. Dans un autre mode de réalisation, le module photovoltaïque 1 est associé au câble porteur 4a et au câble tracteur 4b par un connecteur 5 qui est un connecteur débrayable. A l'arrivée en station, le module photovoltaïque 1 est déconnecté électriquement et l'ensemble formé par le connecteur 5 et le module photovoltaïque 1 est désolidarisé du ou des câbles aériens 4. Cela permet de supprimer ou de remplacer rapidement un module photovoltaïque 1 défaillant. La zone de stockage peut être munie d'un ou de plusieurs modules photovoltaïques 1 de dépannage.

Le débrayage permet d'avoir une vitesse et/ou des directions différentes entre le connecteur 5 et le câble tracteur 4b. Dans un mode de réalisation particulier, le connecteur 5 peut être muni d'une pince qui définit une position fermée et une position ouverte. Dans la position fermée, la pince est accrochée fixement au câble tracteur 4a et dans la position ouverte le câble tracteur 4b est en mesure de se déplacer librement par rapport à la pince. La pince peut être connectée à un actionneur, par exemple sous la forme d'un levier, qui agit sur la pince afin de définir son état entre la position fermée et la position ouverte. La station 6 peut être muni d'un guide qui agit sur l'actionneur pour placer la pince dans la position ouverte lorsque le connecteur atteint une zone prédéfinie de la station 6. Lorsque le connecteur 5 atteint la zone prédéfinie, la pince s'ouvre et le module photovoltaïque 1 n'est plus entrainé par le câble aérien. Le connecteur 5 est entrainé par un support 6a qui déplace le module photovoltaïque 1 à une vitesse différente et/ou dans une direction différente. Le support 6a entraine le module photovoltaïque 1 de la zone prédéfinie jusqu'à la zone de stockage. Le module photovoltaïque se déplace de la position de production jusqu'à la position de repos. Le module photovoltaïque peut réaliser le chemin opposé depuis la position de repos jusqu'à la position de production. Le module photovoltaïque se déplace le long du support 6a jusqu'à atteindre la zone prédéfinie. L'actionneur n'est plus sollicité par le guide et la pince se referme. La pince dans la position fermée monte fixement le connecteur avec le câble tracteur ce qui permet le déplacement du module photovoltaïque 1 jusqu'à sa position de production. L'utilisation d'une pince débrayable permet un passage entre la position de repos et la position de production qui est automatisé, c'est-à-dire sans intervention d'un opérateur qui agit directement sur le connecteur comme cela est le cas dans les enseignements de l'art antérieur. La traversée de la station 6 ou de la station additionnelle 10 pour déplacer les modules photovoltaïques 1 entre le premier brin et le deuxième brin permet de réduire le nombre de module photovoltaïque à retirer du câble aérien en cas d'intervention de maintenance.

Il est également possible de supprimer le module photovoltaïque 1 défaillant et d'accrocher de nouveaux les autre modules photovoltaïques 1 en prenant la place du module photovoltaïque 1 défaillant ou en laissant la place libre et en le remplaçant par un prolongateur pour assurer la fixation de la liaison électrique 2.

En outre, durant une opération de maintenance, tout ou partie des autres modules photovoltaïques 1 peuvent être maintenus dans une position de production. Une modification d'une ou plusieurs liaisons électriques 2 peut être réalisée avant d'effectuer l'intervention. Un tel mode de réalisation permet d'augmenter le taux d'utilisation du générateur électrique.

Dans un mode de réalisation particulier, le générateur électrique est muni d'une zone de stockage qui est apte à stocker tout ou partie de la pluralité des modules photovoltaïques 1. De préférence, la zone de stockage est une partie de la station 6. Dans la position de repos, le module photovoltaïque 1 est désolidarisé du câble aérien 4, c'est-à-dire du câble tracteur 4b et du câble porteur 4a. Il est possible d'intervenir sur le câble sans avoir à effectuer une opération supplémentaire sur les modules photovoltaïques 1.

Le générateur électrique est muni d'un circuit de commande 9 connecté au dispositif de déplacement 7 de manière à commander le déplacement des modules photovoltaïques 1 entre la position de production et la position de repos en déplaçant le câble tracteur 4b.

L'utilisation de modules photovoltaïques 1 dissociés mécaniquement les uns des autres autrement que par le câble tracteur 4b et la liaison électrique 2 est particulièrement avantageuse lorsque le câble aérien 4 ne définit pas une ligne droite entre la station 6 et la station additionnelle 10 dans une observation verticale, c'est-à-dire avec un virage à droite ou à gauche.

Dans un autre mode de réalisation, les modules photovoltaïques 1 sont connectés mécaniquement et directement les uns derrière les autres par des éléments de liaison qui définissent des liaisons pivots. L'axe de pivotement est perpendiculaire à l'axe longitudinal du câble aérien 4 ou sensiblement perpendiculaire. L'axe de pivotement est préférentiellement horizontal ou sensiblement horizontal.

L'utilisation des liaisons pivots permet de moduler l'encombrement de l'ensemble de modules photovoltaïques 1 selon la direction longitudinale. La liaison pivot permet de gérer des phénomènes de dilatation différentielle entre les connecteurs 5 accrochés au câble tracteur 4b et les modules photovoltaïques 1.

L'utilisation des liaisons pivots est particulièrement avantageuse en association avec des connecteurs débrayables qui permettent la désolidarisation du câble aérien 4 dans la station 6 ou la station additionnelle 10.

Lorsque le câble tracteur 4b se déplace pour emmener le et les modules photovoltaïques 1 de la position de production à la position de repos, les modules photovoltaïques 1 entrent dans la station les uns derrière les autres. Dans une volonté de réduction de l'encombrement des modules photovoltaïques 1 dans la zone de stockage. Il est avantageux de replier les modules photovoltaïques 1 les uns contre les autres. Le débrayage du connecteur débrayable depuis le câble tracteur 4b jusqu'à un support 6a, par exemple un rail, se traduit par une réduction de la vitesse. La réduction de vitesse fait que la partie de l'ensemble solidaire du support 6a se déplace moins vite que le câble tracteur 4b fixé au reste de l'ensemble. Cela engendre un effort sur le module photovoltaïque 1 qui tend à se plier.

Comme cela est illustré à la figure 6, le pliage se propage sur l'ensemble des modules photovoltaïques 1 au fur et à mesure qu'ils passent du câble tracteur 4b au support 6a. Le mouvement inverse permet de déplier les modules photovoltaïques 1 en profitant de l'effort induit par le câble tracteur 4b qui se déplace plus vite que le connecteur accroché au support 6a. Ce mode de réalisation est particulièrement avantageux lorsque le chemin emprunté par l'ensemble de modules photovoltaïques 1 est une ligne droite ce qui simplifie la configuration de la liaison pivot.

Un ensemble de modules photovoltaïques 1 peut être formé par deux modules photovoltaïques 1 ou plus. De préférence, un ensemble de modules photovoltaïques 1 est formé par la moitié des modules photovoltaïques ou par l'intégralité des modules photovoltaïques 1. Lorsque l'ensemble de modules photovoltaïques 1 comprend la moitié des modules photovoltaïques, il est avantageux d'avoir deux ensembles distincts qui sont accrochés aux deux brins du câble tracteur 4b séparés par la station 6 et la station additionnelle 10.

Les modules photovoltaïques 1 sont chacun connectés au câble aérien 4 par au moins un connecteur 5. Dans un mode de réalisation, un connecteur 5 est fixé à chacune des deux extrémités du module photovoltaïque 1 selon la direction longitudinale du câble aérien 4 lorsque le module photovoltaïque 1 est dans la position de production. Les connecteurs 5 sont préférentiellement fixés aux extrémités de deux modules photovoltaïques 1 adjacents. Dans une alternative, le connecteur 5 est fixé à une partie centrale du module photovoltaïque 1.

Dans ce mode de réalisation, il est avantageux que la partie centrale du module photovoltaïque 1 soit munie d'une liaison pivot et que les extrémités liées aux modules photovoltaïques 1 adjacents soient également pourvues d'une liaison pivot. Le module photovoltaïque 1 peut être décomposé en deux panneaux photovoltaïques reliés par une liaison pivot.

Il est également possible de prévoir des modules photovoltaïques 1 qui sont connectés au câble aérien 4 par deux connecteurs 5 débrayables disposés aux deux extrémités du module photovoltaïque 1 selon la direction longitudinale lorsque le module photovoltaïque 1 est en position de production. Chaque module photovoltaïque 1 est dissocié des autres. Le module photovoltaïque 1 possède dans sa portion centrale une liaison pivot qui permet de plier ou de déplier le module photovoltaïque 1. La différence de vitesse qui existe entre le connecteur 5 débrayable associé au support 6a et le connecteur 5 débrayable associé au câble tracteur 4b permet de plier ou de déplier le module photovoltaïque 1. L'encombrement est différent entre la position de repos et la position de production.

De manière plus générale, pour réaliser un stockage des modules photovoltaïques 1 dans des conditions avantageuses, il est intéressant que les modules photovoltaïques 1 soit fixés au moyen d'un ou plusieurs connecteurs 5 débrayables et que le module photovoltaïque 1 soit pliable.

Le connecteur 5 débrayable peut être une pince bien connue du domaine du transports par câble, notamment du transport des biens ou du transport des personnes et de préférence par câble aérien. Il est avantageux que la station 6 possède un rail ou tout autre dispositif de support équivalent qui relie le câble tracteur 4b et la zone de stockage de manière à pouvoir débrayer le module photovoltaïque 1 du câble tracteur 4b pour le déplacer vers la zone de stockage.

De manière préférentielle, le circuit de commande 9 est muni ou est relié à un module météorologique. Le module météorologique reçoit et/ou calcule des informations relatives à des données météorologiques.

Par exemple, suite à la détection de conditions météorologiques néfastes, le circuit de commande 9 du générateur électrique peut commander le stockage d'au moins une partie des modules photovoltaïques 1 voire de tous les modules photovoltaïques 1 dans la position de repos. Dans un mode de réalisation particulier, un signal représentatif de conditions météorologiques néfastes est choisi parmi un signal représentatif d'un épisode de grêle, d'un épisode de vent violent, un épisode de neige. Il peut en être de même suite à la détection d'un signal représentatif d'un épisode d'orage accompagné de production de foudre. Dans ce dernier cas de figure, une unique intervention sur le circuit électrique peut être envisagée pour isoler électriquement les modules photovoltaïques 1.

Dans un mode de réalisation particulier, dans la position de production, les modules photovoltaïques 1 sont montés mobiles par rapport au connecteur 5. Préférentiellement, les modules photovoltaïques 1 sont montés mobiles à pivotement de sorte que le plan du panneau photovoltaïque 1a destiné à capter le rayonnement solaire peut ajuster la valeur de son inclinaison par rapport à la verticale ou à la direction Nord-Sud pour déplacer la surface de collecte du rayonnement solaire et suivre la course du soleil. Le circuit de commande 9 peut être configuré pour ajuster l'inclinaison du plan de collecte du rayonnement solaire tout au long de la journée pour suivre la course du soleil. L'ajustement peut être indépendant pour chaque module photovoltaïque 1. L'ajustement peut être réalisé au moyen d'un moteur fixé au connecteur 5 et au module photovoltaïque 1.

Les orientations tridimensionnelles des différentes portions du câble porteur 4a et du câble tracteur 4b sont connues entre la station 6 et la station additionnelle 10. La position des multiples pylônes 3 est connue. Les orientations tridimensionnelles du câble aérien 4 comportent son écart angulaire à la direction Nord-Sud ainsi que son écart angulaire par rapport à la verticale. L'ombrage apporté par un pylône peut également être calculé en fonction de la course du soleil. Ces informations permettent de calculer la position des modules photovoltaïques entre la station 6 et la station additionnelle 10 pour optimiser le rendement de collecte du rayonnement solaire. Ces informations sont également utilisables pour définir une inclinaison personnalisée pour chaque module photovoltaïque 1 et pour ajuster les valeurs d'inclinaison si le câble tracteur 4b se déplace.

Dans un mode de réalisation particulier, la position de chaque module photovoltaïque 1 par rapport à un point de référence est déterminée, par exemple en calculant la longueur de déplacement du câble tracteur 4b depuis le point de référence. Il est alors possible de connaitre pour chaque module photovoltaïque 1 sa position et donc le décalage angulaire qui existe par rapport à la direction Nord-Sud basé sur l'orientation du câble aérien 4. Une fois le module photovoltaïque 1 installé dans la position de production, le circuit de commande 9 peut calculer la position du module photovoltaïque 1 le long de la boucle du câble tracteur 4b et ajuster l'inclinaison du module photovoltaïque 1 par rapport à la direction Nord-Sud.

Dans un mode de réalisation, le module photovoltaïque 1 possède un bras 1c qui est monté librement pivotant par rapport au câble porteur 4a de manière à s'aligner avec une orientation de référence indépendamment de l'inclinaison du câble porteur 4a par rapport à la direction verticale. Préférentiellement, le bras 1c est monté librement pivotant pour suivre le vecteur gravité en utilisant la masse du module photovoltaïque 1. Un tel mode de réalisation permet d'avoir un plan de référence pour le module photovoltaïque 1 indépendant de l'inclinaison du câble porteur 4a. Le plan de référence est par exemple un plan horizontal.

Un tel mode de réalisation est particulièrement avantageux lorsque le générateur électrique s'étend sur un terrain qui n'est pas horizontal. Par exemple, le générateur est muni de plusieurs pylônes 3 et l'inclinaison du câble porteur 4a varie entre deux pylônes 3 successifs. Le bras 1c permet d'éliminer ou de réduire l'inclinaison du câble porteur 4a sur les performances de collecte du module photovoltaïque 1. Sur une distance importante, le câble porteur 4a se déforme. Il est donc préférable d'avoir un bras 1c qui compense les aléas d'inclinaison. Lorsque les deux brins opposés du câble porteur 4a sont utilisés, la position du câble porteur 4a par rapport au sol varie selon le poids appliqué au câble porteur 4a, c'est-à-dire selon le nombre de modules photovoltaïques 1 installés. Le bras 1c permet de s'affranchir d'une évolution du nombre de modules photovoltaïques installés et/ou d'une modification de la masse des modules photovoltaïques installés.

L'utilisation d'un tel bras 1c permet de faciliter le calcul de l'inclinaison de la surface de collecte pour optimiser le rendement de production d'électricité. Par exemple, afin de suivre la course du soleil, le circuit de commande 9 peut calculer une inclinaison en tenant uniquement compte du décalage angulaire par rapport à la direction Nord-Sud pour chaque module photovoltaïque 1. Si le câble porteur 4a s'étend en ligne droite, dans une observation verticale, le bras 1c permet de compenser l'inclinaison du câble porteur 4a sous son poids et celui des modules photovoltaïques 1.

Dans un mode de réalisation, l'inclinaison par rapport à la direction verticale est fortement variable selon les multiples positions accessibles au module photovoltaïque 1 et le au moins un bras 1c reproduit tout ou partie de l'inclinaison. Le calcul de la position exacte de la position de production du module photovoltaïque 1 par rapport au point de référence permet au circuit de commande 9 de calculer l'inclinaison par rapport à la verticale ainsi que l'inclinaison par rapport à la direction Nord-Sud et de modifier l'inclinaison du module photovoltaïque 1 en conséquence pour améliorer le rendement de conversion photovoltaïque.

En alternative, les inclinaisons des surfaces de collecte par rapport à la verticale et/ou par rapport à la direction Nord-Sud sont définies individuellement pour chaque module photovoltaïque 1. Les modules photovoltaïques 1 sont accrochés au câble tracteur 4b en des positions précises et le circuit de commande 9 calcule le déplacement du câble tracteur 4b afin de placer les modules photovoltaïques dans la position attendue le long de la boucle. Le câble tracteur 4b est déplacé de sorte que les modules photovoltaïques 1 soient dans la position correspondant aux inclinaisons appliquées à la surface de collecte 1a.

Dans un mode de réalisation particulier, les modules photovoltaïques 1 sont montés mobiles à pivotement par rapport au connecteur 5. Suite à la détection de conditions représentatives d'un épisode météorologique intense, le circuit de commande 9 peut décider de modifier l'inclinaison des modules photovoltaïques 1 par rapport à la direction verticale. Par exemple, suite à la détection d'une chute de neige et/ou suite à la détection de conditions annonciatrices d'un épisode de grêle, il est avantageux d'incliner les modules photovoltaïques 1 pour que la surface de collecte soit verticale, c'est-à-dire pour que le vecteur normal à la surface de collecte du module photovoltaïque 1 se rapproche d'une direction horizontale, c'est-à-dire que la tranche du panneau photovoltaïque s'étend verticalement ou majoritairement verticalement. Il peut en être de même suite à la détection de conditions annonciatrices d'un épisode de pluie chargée de sable ou d'autres particules aptes à se déposer sur la surface collectrice 1a du module photovoltaïque 1 et à réduire la valeur de transmittance.

Dans un autre mode de réalisation, suite à la détection de vents ayant une vitesse supérieure à une valeur seuil et/ou suite à la détection de conditions annonciatrices d'un épisode de vents dont la vitesse est supérieure à la vitesse seuil, il est avantageux d'incliner les modules photovoltaïques 1 pour que la prise au vent soit plus faible et de préférence la plus faible possible. Il est avantageux que le vecteur normal à la surface du module photovoltaïque 1 se rapproche d'une direction verticale.

Ces actions du circuit de commande 9 peuvent être engagées avant de réaliser le stockage d'une partie ou de tous les modules photovoltaïques 1 dans la zone de stockage lorsque les conditions météorologiques se dégradent.

Lorsque les modules photovoltaïques 1 sont fixés au moyen d'un connecteur fixe et/ou que le générateur électrique est dépourvu d'une zone de stockage apte à stocker au moins 50% des modules photovoltaïques 1, il est avantageux de prévoir des modules photovoltaïques 1 qui sont montés à pivotement afin d'ajuster l'angle d'inclinaison par rapport à la direction verticale et/ou par rapport à la direction Nord-Sud afin d'ajuster les effets des conditions météorologiques, par exemple la prise au vent ou la direction de chute de la pluie, de neige ou de la grêle.

Afin d'améliorer la quantité de courant électrique à produire, il est avantageux d'augmenter la surface de collecte en augmentant la longueur des modules photovoltaïques 1, c'est-à-dire la dimension selon la direction longitudinale du câble aérien 4. Lorsque la longueur des modules photovoltaïques 1 atteint une valeur seuil, il est avantageux de fixer les modules photovoltaïques 1 au moyen de deux dispositifs d'accrochage qui se trouvent aux deux extrémités opposées des modules photovoltaïques 1 selon la direction longitudinale du câble aérien 4.

Il est avantageux que les modules photovoltaïques 1 soient accrochés au câble aérien 4 au moyen de connecteurs débrayables c'est-à-dire des connecteurs qui peuvent s'accrocher ou se décrocher du câble aérien 4. Les connecteurs 5 peuvent être réalisés selon les mêmes technologiques que ceux utilisés dans les installations de transport par câble et de préférence de type téléphérique.

Lorsque le module photovoltaïque 1 est accroché au câble aérien 4 par au moins deux connecteurs débrayables qui sont décalés selon la direction longitudinale ou la direction de déplacement du module photovoltaïque 1, il est avantageux que le module photovoltaïque 1 possède une longueur qui est variable entre les deux connecteurs débrayables. Par exemple, le module photovoltaïque 1 est plié ou pliable avec une charnière 1b définissant une ligne de pliure qui est sécante à la direction longitudinale du câble aérien 4 dans une observation selon une direction perpendiculaire à l'axe longitudinale, par exemple une direction verticale. Le module photovoltaïque 1 possède une première longueur lorsque les connecteurs 5 sont fixés au au moins un câble tracteur 4b et une deuxième longueur lorsque les connecteurs 5 sont détachés du au moins un câble tracteur 4b.

Dans la position de repos, le module photovoltaïque 1 possède un encombrement moindre que dans la position de production. Cette configuration permet d'avoir une zone de stockage de taille réduite tout en étant apte à stocker tout ou partie des modules photovoltaïques 1 avec leurs connecteurs 5.

L'utilisation d'un module photovoltaïque 1 qui est fixé au câble aérien 4 uniquement par deux connecteurs débrayables et dont la longueur est variable peut se stocker plus facilement dans une zone de stockage et il peut contourner plus facilement une poulie de renvoi ou d'entrainement. En plus d'être pliable, le module photovoltaïque 1 peut être inclinable par rapport à la direction verticale et/ou la direction Nord-Sud.

En cas de défaillance d'un module photovoltaïque 1 et/ou de sa connexion électrique, il est possible de déplacer le câble tracteur 4b de manière à ramener le module photovoltaïque 1 défaillant depuis sa position de production jusqu'à sa position de repos puis de l'exclure avant d'accrocher de nouveau les autres modules photovoltaïques 1 si ces derniers ont été décrochés.

Il est encore possible de remplacer le module photovoltaïque 1 par un panneau de remplacement afin que le générateur électrique maintienne sa production électrique attendue. Comme pour le remplacement ou l'exclusion d'un véhicule dans une installation de transport par câble, le remplacement ou l'exclusion d'un module photovoltaïque 1 peut être réalisé dans un délai très court avec peu ou pas de personnel.

Dans un mode de réalisation particulier, le générateur électrique est muni d'une station additionnelle 10 qui est également munie d'une zone de stockage, par exemple un local de stockage. Une partie des modules photovoltaïques 1 est stockée dans la station 6 et une autre partie des modules photovoltaïques 1 est stockée dans la station additionnelle 10. Cette configuration est avantageuse lorsque la station 6 et la station additionnelle 10 sont installées à des altitudes différentes de manière à définir une station haute et une station basse. Préférentiellement, la moitié des modules photovoltaïques 1 peut être stockée dans la station haute et l'autre moitié des modules photovoltaïques 1 peut être stockée dans la station basse. Lors du passage d'une position de repos à une position de production, il est avantageux que la moitié des modules photovoltaïques se déplace depuis la station haute et que l'autre moitié des modules photovoltaïques 1 se déplace depuis la station basse. Le poids des modules photovoltaïques 1 se déplaçant depuis la station haute aide au déplacement des modules photovoltaïques 1 qui se déplacent depuis la station basse. Corollairement, lors du passage de la position de production à la position de repos, le poids des modules photovoltaïques 1 se déplaçant vers la station basse aide au déplacement des modules photovoltaïques 1 en direction de la station haute. Cela permet de réduire fortement la consommation du dispositif d'entrainement 7.

Lorsque les modules photovoltaïques sont accrochés avec des pinces fixes, il est avantageux de répartir uniformément les modules le long de la boucle de sorte qu'une augmentation d'altitude d'un nombre de modules photovoltaïques accrochés à un brin du câble tracteur 4b se traduit par une baisse d'altitudes pour un nombre équivalent de modules photovoltaïques accroché à l'autre brin du câble tracteur. Les efforts liés au déplacement du câble tracteur sont réduits.

De manière préférentielle, les modules photovoltaïques 1 sont attachés et détachés indépendamment les uns des autres au câble aérien 4 ce qui facilite les opérations de maintenance et l'adaptation du générateur électrique aux conditions météorologiques. Les modules photovoltaïques 1 sont reliés à une borne de sortie d'un courant électrique au moyen d'une liaison électrique 2. De manière préférentielle, les modules photovoltaïques 1 sont reliés les uns aux autres au moyen d'une liaison électrique 2. Dans un mode de réalisation particulier, la liaison électrique 2 s'étend depuis la station 6 jusqu'à chaque module photovoltaïque 1 ou une partie des modules photovoltaïques 1. Les autres modules photovoltaïques 1 sont reliés à la station additionnelle 10 par une autre liaison électrique 2.

La modification du nombre de modules photovoltaïques 1 accrochés au câble aérien 4 peut être réalisée facilement en intervenant sur la liaison électrique 2.

Il est avantageux que les modules photovoltaïques 1 soient accrochés indépendamment les uns aux autres au câble aérien 4. Préférentiellement, deux modules photovoltaïques 1 adjacents sont connectés par une liaison électrique 2, par exemple un câble électriquement conducteur. Le câble électriquement conducteur peut avoir une longueur supérieure ou égale à la distance de séparation entre deux modules photovoltaïques 1 ou il peut être déformable élastiquement.

Il est avantageux que deux modules photovoltaïques 1 soient connectés uniquement par un lien souple, par exemple le câble aérien 4 et éventuellement le lien électrique 2 entre les modules photovoltaïques 1. Les deux modules photovoltaïques 1 peuvent se mouvoir les uns par rapport aux autres ce qui permet de mieux s'adapter aux efforts du vent. Il est désavantageux de connecter plusieurs modules photovoltaïques 1 avec des connexions rigides ce qui induit des efforts importants lorsque le générateur électrique est soumis au vent.

Le générateur électrique est destiné à alimenter un réseau électrique et/ou une charge électrique. Les modules photovoltaïques 1 peuvent être connectés en série ou en parallèle. Les modules photovoltaïques 1 peuvent être connectés indépendamment les uns les autres à la borne de sortie du générateur électrique. En alternative, les modules photovoltaïques 1 sont connectés les uns aux autres, par exemple les uns derrière les autres. Le dernier module photovoltaïque 1 est connecté à la borne de sortie.

Dans un mode de réalisation particulier, une installation de transport par câble peut être convertie en un générateur électrique. Des modules photovoltaïques 1 sont accrochés au câble aérien 4 au moyen d'au moins un connecteur 5. Cela permet d'utiliser l'infrastructure existante de l'installation de transport par câble pour y accrocher les modules photovoltaïques 1. L'installation de transport par câble est munie de deux stations qui sont reliées par au moins un câble tracteur et au moins un câble porteur. Le câble tracteur peut être le câble porteur. L'installation de transport par câble est munie de moyens d'entrainement, par exemple un moteur, qui sont configurés pour entrainer en rotation le câble tracteur qui définit une boucle reliant la station 6 avec la station additionnelle 10.

L'installation de transport par câble est munie d'un ou de plusieurs véhicules, par exemple des cabines et/ou des sièges. Les véhicules sont initialement fixés au câble aérien 4. Les véhicules sont détachés du câble aérien 4 et ils sont remplacés par des modules photovoltaïques 1.

L'installation de transport par câble peut être une télécabine, un télésiège, un téléphérique, un funitel ou un télémix/combi. L'installation de transport par câble peut être munie de pinces débrayables ou de pinces fixes pour accrocher les véhicules aux câbles. Il est avantageux de conserver la même technologie de pince lors de la transformation de l'installation de transport par câble en un générateur d'énergie électrique photovoltaïque.

Par exemple, une installation de transport destinée aux activités hivernales ou à une ou plusieurs autres périodes peut être convertie en générateur électrique durant le reste de l'année. Ce type de conversion peut également être envisagé lorsque l'activité de transport de personnes ou de biens est arrêtée ce qui permet de profiter des infrastructures déjà réalisées.

La conversion s'effectuant par remplacement des véhicules par des modules photovoltaïques, la conversion peut être réalisée rapidement.

Les remontées mécaniques sont généralement installées dans des endroits soumis à des conditions climatiques intenses avec des vents violents, de la neige, de la grêle et de la pluie. Le générateur électrique apparait particulièrement bien adapté à ces conditions car il permet d'avoir des modules photovoltaïques qui sont aptes à résister à des vitesses de vents importantes, de modifier leur inclinaison afin d'être moins sensibles aux effets de la neige, de la grêle et de la pluie. Le générateur électrique peut fonctionner avec une intervention humaine réduite. Il permet également d'avoir une consommation électrique faible en réduisant l'occurrence d'un déplacement des panneaux depuis la position de production jusqu'à la position de repos. En outre, si les modules peuvent être stockés dans la station basse et dans la station haute, la consommation électrique est fortement réduite ce qui améliore fortement le bilan énergétique du générateur électrique.

Par exemple, si un module photovoltaïque 1 est considéré comme défaillant, il est possible de déplacer au moins une partie des modules photovoltaïques jusqu'à la zone de repos et d'intervenir lorsque le soleil est couché ou lorsque le rayonnement émis est inférieur à une valeur seuil. Une fois le module photovoltaïque dans la position de repos, une intervention peut être réalisée ou un remplacement est opéré. Les modules photovoltaïques peuvent ensuite être installés de nouveau dans la position de production pour la prochaine course du soleil.

Lorsque les modules photovoltaïques sont disposés au-dessus de zones agricoles et/ou au-dessus d'exploitations animales, les interventions sont réalisées à distance de la zone d'exploitation animale ou agricole.

## Revendications

1. Générateur électrique (1) comportant :
- des modules photovoltaïques (1) définissant chacun une surface de collecte destinée à collecter du rayonnement solaire ;
- une station (6) munie d'une poulie, la station (6) définissant au moins un local de stockage apte à stocker au moins une partie des modules photovoltaïques (1) dans une position de repos ;
- une poulie de renvoie ;
- au moins un câble aérien (4) définissant une boucle qui relie la poulie et la poulie de renvoie, le au moins un câble aérien (4) étant destiné à supporter les modules photovoltaïques (1) et comportant au moins un câble tracteur (4b) destiné à déplacer les modules photovoltaïques (1) accrochés audit au moins un câble tracteur (4b) ;
- un dispositif de déplacement configuré pour déplacer le au moins un câble tracteur (4b) et déplacer les modules photovoltaïques (1) le long de la boucle par rapport à la au moins une station (6) ;
- une pluralité de connecteurs (5), chaque module photovoltaïque (1) étant fixé audit au moins un câble tracteur (4b) au moyen d'au moins un des connecteurs (5) ;
- un circuit de commande (9) configuré pour commander le dispositif de déplacement et déplacer au moins une partie des modules photovoltaïques (1) d'une position de production à la position de repos, la position de production étant disposée entre la poulie et la poulie de renvoie ;
**caractérisé en ce que** les connecteurs (5) sont des connecteurs débrayables pour désolidariser les modules photovoltaïques (1) et le au moins un câble aérien en station, la station (6) possédant un dispositif de support (6a) qui relie le au moins un câble tracteur (4b) et le local de stockage de manière à pouvoir débrayer le module photovoltaïque (1) du au moins un câble tracteur (4b) pour déplacer le module photovoltaïque (1) vers le local de stockage, le connecteur (5) se déplaçant à une vitesse différente et/ou des directions différentes par rapport audit au moins un câble tracteur (4b), les connecteurs (5) circulant le long du dispositif de support étant déconnectés du au moins un câble aérien (4) dans la position de repos.

2. Générateur électrique selon revendication 1 dans lequel le au moins câble tracteur (4b) définit une boucle divisée en un premier brin et un deuxième brin reliant chacun la poulie et la poulie de renvoie, dans lequel dans la position de production une partie des modules photovoltaïques (1) est uniquement accrochée au premier brin et une deuxième partie des modules photovoltaïques (1) est accrochée uniquement au deuxième brin.

3. Générateur électrique selon la revendication 2 dans lequel le au moins un câble tracteur (4b) est également au moins un câble porteur (4a) supportant les modules photovoltaïques (1) dans la position de production.

4. Générateur électrique selon l'une quelconque des revendications 1 à 3 dans lequel chaque module photovoltaïque (1) est fixé audit au moins un câble tracteur (4b) au moyen d'au moins un connecteur spécifique, chaque module photovoltaïque (1) étant mobile selon deux directions perpendiculaires à une direction longitudinale du câble aérien (4) indépendamment des autres modules photovoltaïques (1).

5. Générateur électrique selon la revendication 4 dans lequel, dans la position de production, les modules photovoltaïques (1) adjacents accrochés indépendamment audit au moins un câble tracteur (4b) et sont uniquement reliés par une connexion souple pour être montés mobiles les uns par rapport aux autres selon au moins une direction perpendiculaire à un axe longitudinal du au moins un câble aérien (4) par déformation du au moins un câble aérien (4).

6. Générateur électrique selon la revendication 5 dans lequel chaque module photovoltaïque (1) est connecté au connecteur (5) par un bras (1c), le bras (1c) étant librement pivotant par rapport au connecteur (5) pour suivre le vecteur gravité indépendamment de l'inclinaison du au moins un câble porteur (4a) et figer l'inclinaison de la surface de collecte par rapport à la direction verticale, les modules photovoltaïques (1) étant disposés sous le au moins un câble porteur (4a).

7. Générateur électrique selon la revendication 6 dans lequel chaque module photovoltaïque (1) comporte un dispositif de pivotement configuré pour faire pivoter la surface de collecte par rapport au bras (1c) et au connecteur et pour ajuster une inclinaison de la surface de collecte du module photovoltaïque (1) par rapport au bras et par rapport à une direction verticale dans la position de production, l'ajustement étant réalisé selon au moins une direction.

8. Générateur électrique selon la revendication 7 dans lequel, l'ajustement est réalisé selon deux directions orthogonales.

9. Générateur électrique selon l'une quelconque des revendications 1 à 8 dans lequel le circuit de commande (9) est muni ou relié à un module météorologique et configuré pour modifier l'inclinaison de la surface de collecte à réception d'un signal représentatif de conditions météorologiques prédéterminées constituées par des vitesses de vents supérieures à une vitesse seuil, un épisode de grêle, une chute de neige, un épisode pluvieux, les modules photovoltaïques (1) étant dans la position de production et/ou pour déplacer les modules photovoltaïques (1) de la position de production à la position de repos à réception d'un signal représentatif de conditions météorologiques néfastes constitué par des vitesses de vents supérieures à une vitesse seuil, un épisode de grêle, une chute de neige.

10. Générateur électrique selon l'une quelconque des revendications 1 à 9 dans lequel au moins l'un des modules photovoltaïques (1) est fixé au câble tracteur (4b) par deux connecteurs débrayables et dans lequel ledit au moins un des modules photovoltaïques (1) est pliable au moyen d'au moins une liaison pivot disposée entre deux panneaux photovoltaïques connectés chacun audit au moins un câble tracteur par un connecteurs débrayable pour augmenter ou réduire une longueur du au moins un des modules photovoltaïques (1) par pliage entre les deux connecteurs débrayables entre la position de repos et la position de production, la longueur du module photovoltaïque (1) étant mesurée selon la direction longitudinale du au moins un câble aérien ou une direction de déplacement du module photovoltaïque (1).

11. Générateur électrique selon l'une quelconque des revendications 2 à 10 comportant une station additionnelle (10) munie de la poulie de renvoie et disposée à une altitude différente de la station (6), dans lequel la station additionnelle (10) définit au moins un local de stockage apte à stocker une partie des modules photovoltaïques (1) et dans lequel dans un état de repos une première partie des modules photovoltaïques (1) est stockée dans la station (6) et une deuxième partie des modules photovoltaïques (1) est stockée dans la station additionnelle (10), les modules photovoltaïques étant répartis sur le premier brin et le deuxième brin, les modules photovoltaïques (1) en position de production étant disposés sur le premier brin et le deuxième brin de la boucle reliant la station (6) et la station additionnelle (10).

12. Générateur électrique selon la revendication 11 dans lequel plusieurs des modules photovoltaïques sont connectés à chacune de leurs extrémités selon la direction longitudinal du au moins un câble aérien (4) à deux modules photovoltaïques (1) adjacents, dans lequel le module photovoltaïque (1) est connecté audit module photovoltaïque (1) adjacent par une liaison pivot.

13. Générateur électrique selon la revendication 12 dans lequel les modules photovoltaïques (1) sont accrochées audit au moins un câble aérien (4) par deux connecteurs (5) disposés aux extrémités opposées du module photovoltaïque (1) selon la direction longitudinale pour former deux connecteurs d'extrémité, dans lequel les connecteurs d'extrémité accrochent deux modules photovoltaïques (1) adjacents et dans lequel les deux modules photovoltaïques (1) adjacents sont reliés par une liaison pivot.

14. Procédé de conversion d'une installation de transport par câble en générateur d'énergie selon l'une quelconque des revendications 1 à 13 comportant les étapes suivantes :
- fournir une installation de transport par câble comportant des véhicules, une station (6) et une station additionnelle (10) reliée par au moins un câble aérien (4) destiné à supporter les véhicules et comportant au moins un câble tracteur (4b) destiné à déplacer les véhicules, chaque véhicule étant fixé au câble tracteur (4b), l'installation comportant également un dispositif de déplacement du au moins un câble tracteur (4b) pour déplacer les véhicules le long de la boucle par rapport à la au moins une station (6) ;
- remplacer les véhicules par les modules photovoltaïques (1) ;
et dans lequel un circuit de commande (9) est configuré pour déplacer les modules photovoltaïques (1) d'une position de production à une position de repos en déplaçant le au moins un câble tracteur (4b).

15. Procédé d'utilisation d'un générateur d'énergie selon l'une quelconque des revendications 1 à 13 comportant les étapes suivantes :
- déplacer le câble tracteur (4b) pour déplacer au moins des modules photovoltaïques (1) depuis une position de production jusqu'à une position de repos.
